# EUROPEAN PATENT APPLICATION

(11) **EP 4 811 981 A1**
(43) Date of publication of application: **23.09.2026**
(21) Application number: 25745504.8
(22) Date of filing: 06.01.2025
(51) Int. Cl.: H10H 29/855, H10H 29/856, H10H 29/85, H10H 29/14, G09F 9/302

(54) **DISPLAY DEVICE AND DISPLAY SYSTEM**

(30) Priority: 24.01.2024 JP 2024008634
(71) Applicant: Samsung Electronics Co., Ltd., Suwon-si, Gyeonggi-do 16677 (KR)
(72) Inventor: KIM, Dohoon, Yokohama-shi, Kanagawa 230-0027 (JP); AOKI, Dai, Yokohama-shi, Kanagawa 230-0027 (JP); SATO, Atsushi, Yokohama-shi, Kanagawa 230-0027 (JP)
(74) Representative: Gulde & Partner
(86) International application number: PCT/KR2025/000252
(87) International publication number: WO 2025/159396

(57) **Abstract**

The present invention relates to a display device capable of displaying a high-quality image while using small-sized and high-brightness light-emitting elements. According to an embodiment of the present disclosure, the display device includes: a plurality of light-emitting elements which are disposed to be spaced apart from each other on a circuit board and which emit light forward; a reflective layer, which is formed on a transparent substrate facing the circuit board, includes openings formed at positions corresponding to the light-emitting elements, causes the light emitted from the light-emitting elements to pass through the opening and be emitted forward, and reflects the light from the front; and a light-blocking layer which is formed between the circuit board and the transparent substrate, and which absorbs some of the light emitted from the light-emitting elements so that the light emitted from the light-emitting elements does not reach the openings disposed at positions not corresponding to the light-emitting elements.

## Description

### [Technical Field]

The present invention relates to a display device and a display system.

### [Background Art]

A mirror display including both a mirror function of reflecting light and illuminating surrounding objects is known.

The mirror display may be an organic light emitting display device provided with a first substrate having a plurality of organic light emitting elements, and a second substrate having a reflective layer in which a plurality of openings are formed at positions corresponding to the plurality of organic light emitting elements. The organic light emitting display device may realize the mirror function by the reflective layer reflecting light, and may realize the display function by emitting light emitted from the organic light emitting element to the outside through the opening. Further, a mirror function with high reflectivity may be realized by the reflective layer, and a display function with high display luminance may be realized without losing light through the opening.

### [Detailed Description of the Invention]

### [Technical Problem]

A display device having both the display function and the mirror function may require higher display luminance and higher reflectivity. Accordingly, recently, applying small and high-luminance light emitting elements such as a micro light emitting diode (LED) is being considered. Since the micro LED is an inorganic LED, high display luminance may be realized, and since a chip size is small, high reflectivity may be realized by minimizing the opening of the reflective layer. The plurality of micro LEDs constituting each pixel of the display device may be disposed close to each other.

However, when a distance between micro LEDs adjacent to each other is close, light emitted from a specific micro LED may be emitted to the outside through an opening other than the corresponding opening, thereby causing deterioration in image quality of a display image.

The present invention has been made in view illustrating the problem. Therefore, an objective of the present invention is to provide a display device capable of displaying a high-quality image even when using a small and high-luminance light emitting element to realize higher display luminance and higher reflectivity in a display device having both the display function and the mirror function.

Further, another objective of the present invention is to provide a display system comprising a plurality of the display devices.

### [Technical Solution]

The objective of the present invention is achieved by the following means.

According to one aspect of the present disclosure, a display device may be a display device comprising: a plurality of light emitting elements disposed to be spaced apart at regular intervals in a first direction on a circuit board and configured to emit light forward, respectively; a reflective layer formed on a transparent substrate facing the circuit board, the reflective layer comprising openings formed at positions corresponding to the light emitting elements, configured such that light emitted from the light emitting elements passes through the openings and is emitted forward, and configured to reflect light from the front; and a light blocking layer formed between the circuit board and the transparent substrate and configured to absorb a portion of light emitted from the light emitting elements such that light emitted from the light emitting elements does not reach an opening disposed at positions not corresponding to the light emitting elements.

According to one embodiment of the present disclosure, a display device may be a display device wherein the light blocking layer is formed in an area other than an area where the light emitting element is installed on the circuit board.

According to one embodiment of the present disclosure, a display device may be a display device wherein the light blocking layer is configured to cover side surfaces of the light emitting element and to absorb light emitted from the side surfaces of the light emitting elements.

According to one embodiment of the present disclosure, a display device may be a display device wherein the reflective layer further comprises a second light blocking layer formed on a surface facing the light blocking layer.

According to one embodiment of the present disclosure, a display device may be a display device further comprising a transparent adhesive layer formed between the circuit board and the transparent substrate and bonding the circuit board and the transparent substrate.

According to one embodiment of the present disclosure, a display device may be a display device wherein the plurality of light emitting elements comprise a blue light emitting element configured to emit blue light, a green light emitting element configured to emit green light, and a red light emitting element configured to emit red light.

According to one embodiment of the present disclosure, a display device may be a display device wherein the plurality of light emitting elements are light emitting elements that emit light of a specific wavelength, and the display device further comprises a color conversion layer that converts light of the specific wavelength into light of another wavelength and emits the converted light.

According to one embodiment of the present disclosure, a display device may be a display device wherein the color conversion layer is formed in the openings.

According to one embodiment of the present disclosure, a display device may be a display device wherein the transparent substrate has a thickness equal to or less than a preset thickness so that light emitted from the light emitting element does not reach both ends of the transparent substrate in a direction in which the transparent substrate extends.

According to one embodiment of the present disclosure, a display device may be a display device wherein the light emitting elements are configured to overlap the opening when viewed from above.

According to one embodiment of the present disclosure, a display device may be a display device wherein the light emitting elements are micro light emitting diodes (LEDs).

According to one embodiment of the present disclosure, a display device may be a display device wherein the transparent substrate is larger than the circuit board when viewed from above, and wherein a plurality of the circuit boards are bonded to the transparent substrate.

According to one embodiment of the present disclosure, a display system comprising a plurality of display devices may be a display system wherein the plurality of display devices, each having the transparent substrate and the circuit board of an identical size, are disposed in a tile shape.

### [Advantageous Effects]

According to the display device of the present invention, a high-quality image may be displayed even when using a small and high-luminance light emitting element to provide higher display luminance and higher reflectivity.

Further, according to the display system of the present invention, the degree of freedom in the shape of the display plane may be enhanced.

### [Brief Description of Drawings]

FIG. 1 is a plan view illustrating a schematic configuration of a display device 100 according to a first embodiment of the present invention.
FIG. 2 is a cross-sectional view taken along line II-II' of FIG. 1.
FIG. 3A is a view illustrating an optical path in the display device.
FIG. 3B is a view illustrating an optical path in a general display device as a comparative example.
FIG. 4A is a view illustrating an optical path when the transparent substrate is thin.
FIG. 4B is a view illustrating an optical path when the transparent substrate is thick.
FIG. 5A is a view illustrating a method for manufacturing the display device.
FIG. 5B is a view subsequent to FIG. 5A.
FIG. 5C is a view subsequent to FIG. 5B.
FIG. 5D is a view subsequent to FIG. 5C.
FIG. 5E is a view subsequent to FIG. 5D.
FIG. 5F is a view subsequent to FIG. 5E.
FIG. 6 is a cross-sectional view illustrating a schematic configuration of a display device according to a modified example.
FIG. 7 is a cross-sectional view illustrating a schematic configuration of a display device according to a second embodiment.
FIG. 8 is a view illustrating a schematic configuration of a display device according to a third embodiment.
FIG. 9 is a view illustrating a schematic configuration of a display system.

### [Mode for Carrying out the Invention]

Hereinafter, embodiments of the present invention is described in detail with reference to the drawings. In the drawings, the same reference numerals refer to the same components, and the size of each component in the drawings may be exaggerated for clarity and convenience of description. Meanwhile, the embodiments described below are merely exemplary, and various modifications may be made thereto.

Hereinafter, what is described as "upper part" or "upper" may include not only what is directly above in contact, but also what is above without contact. Similarly, what is described as "lower part" or "lower" may include not only what is directly below in contact, but also what is below without contact.

A singular expression includes a plural expression unless the context clearly indicates the singular. Further, when a specific part is said to "include", "have" or "include" a specific component, this means that other components may be further included rather than excluding other components, unless specifically stated to the contrary.

Unless an order is explicitly stated for steps constituting a method, or there is a contrary description, the steps are performed in an appropriate order. The order of description of the steps is not necessarily limited. The use of all examples or exemplary terms is merely for describing the technical spirit, and the scope is not limited by the examples or exemplary terms unless limited by the claims.

### (First Embodiment)

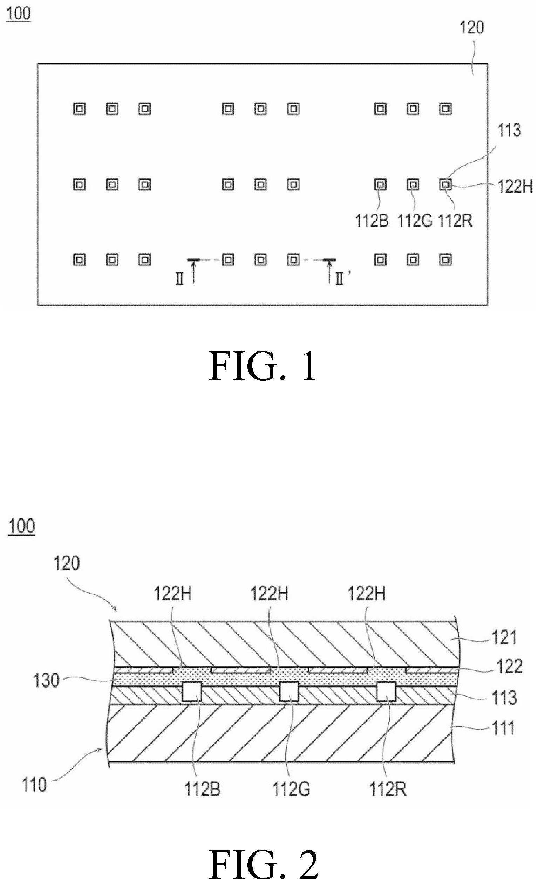

Hereinafter, a display device 100 according to a first embodiment of the present invention is described with reference to FIGS. 1 to 5. The display device 100 according to the present embodiment is a mirror display having both a display function of emitting light to display a desired image and a mirror function of reflecting light to illuminate surrounding objects.

FIG. 1 is a plan view illustrating a schematic configuration of the display device 100 according to the first embodiment of the present invention. FIG. 2 is a cross-sectional view taken along line II-II' of FIG. 1.

As illustrated in FIGS. 1 and 2, the display device 100 of the present invention may include a display substrate 110 in which a plurality of light emitting elements 112G, 112B, 112R (hereinafter, also collectively referred to as "light emitting element 112") are disposed in an array shape, and a reflective substrate 120 in which a plurality of openings 122H exposing the plurality of light emitting elements 112G, 112B, 112R to the outside are formed. The display substrate 110 and the reflective substrate 120 may be bonded to each other through a transparent adhesive layer 130.

### <Display Substrate 110>

The display substrate 110 may be configured by mounting a plurality of light emitting elements 112 on a circuit board 111. Further, a light blocking layer 113 for absorbing a portion of light emitted from the light emitting element 112 may be formed in an area other than the area where the light emitting element 112 is disposed on the circuit board 111.

The circuit board 111 may be a thin film transistor (TFT) substrate on which a TFT, a line layer, etc. (not illustrated) for controlling an operation of the plurality of light emitting elements 112 are formed.

The light emitting element 112 includes a blue light emitting element 112B emitting blue light, a green light emitting element 112G emitting green light, and a red light emitting element 112R emitting red light, and may display a color image. The light emitting elements 112B, 112G, 112R may be micro LEDs having a chip size of 100 µm square or less. Three light emitting elements 112B, 112G, 112R adjacent to each other may constitute one pixel. The three light emitting elements 112B, 112G, 112R may be disposed adjacent to each other at an interval smaller than a pixel size and a pixel pitch.

The light blocking layer 113 may be composed of a black anisotropic conductive film (ACF). The light blocking layer 113 may absorb light emitted from the light emitting element 112 while mechanically and electrically connecting the circuit board 111 and the light emitting element 112. The light emitting element 112 may be formed to be embedded in the light blocking layer 113, and the light blocking layer 113 may be configured to cover a side surface of the light emitting element 112.

### <Reflective Substrate 120>

The reflective substrate 120 may include a transparent substrate 121 and a reflective layer 122. Further, the reflective layer 122 may be formed on one surface of the transparent substrate 121. The transparent substrate 121 may be a transparent glass substrate, and the reflective layer 122 may be composed of an alloy of aluminum and niobium. The reflective layer 122 may function as a mirror surface reflecting light from the front of the display device 100 to illuminate surrounding objects. Meanwhile, a plurality of openings 122H are formed in the reflective layer 122 at positions corresponding to the light emitting elements 112, and the opening 122H may be configured to emit light emitted from the light emitting element 112 forward. The opening 122H may have a rectangular shape and, when viewed from above, the size of the opening 122H may be configured to be slightly larger than the chip size of the light emitting element 112. Further, when viewed from above, the light emitting element 112 may be configured to overlap the opening 122H.

Further, a thin glass substrate having a thickness of about 100 µm may be used as the transparent substrate 121. A detailed description of the thickness of the transparent substrate 121 is described below.

### <Transparent Adhesive Layer 130>

The transparent adhesive layer 130 is disposed between the display substrate 110 and the reflective substrate 120, and may bond the display substrate 110 and the reflective substrate 120 to each other. The transparent adhesive layer 130 may be an optical clear resin (OCR).

According to the display device 100 of the present invention configured as described above, light emitted from the light emitting element 112 is emitted forward through the opening 122H, thereby providing a display function of displaying a desired image. On the other hand, light incident from the front is reflected by the reflective layer 122 of the reflective substrate 120, thereby implementing a mirror function of illuminating surrounding objects.

More specifically, since high-luminance light emitted from the light emitting element 112 is emitted to the outside through the opening 122H, there is no attenuation of light, and a display function with high display luminance may be provided. On the other hand, using the small light emitting element 112, the size of the opening 122H is minimized, and the area of the reflective layer 122 is maximized, thereby providing a mirror function with high reflectivity. Further, since the light blocking layer 113 absorbing a portion of light emitted from the light emitting element 112 is formed, a portion of light emitted from the light emitting element 112 is prevented from being emitted forward through another opening 122H other than the corresponding opening 122H, thereby enhancing the image quality of the display image.

Further, the area ratio of the opening 122H on the surface of the reflective substrate 120 may be 10%, and the area ratio of the reflective layer 122 may be 90%. According to an embodiment, a display device having mirror performance with reflectivity of 83% or more defined in the Japanese Industrial Standards (JIS) may be provided.

### <Display Operation of Display Device 100>

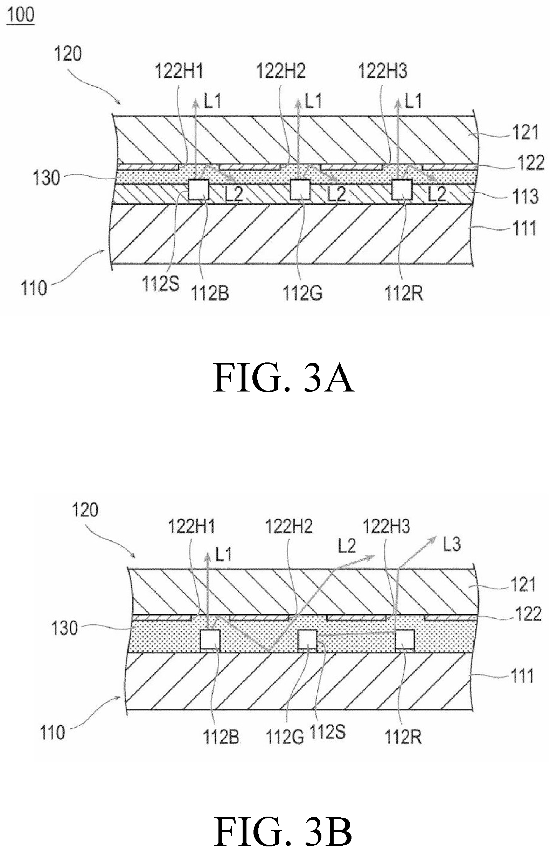

A display operation of the display device 100 is described in detail with reference to FIGS. 3A and 3B. FIG. 3A is a view illustrating an optical path in the display device 100, and FIG. 3B is a view illustrating an optical path in a display device according to a comparative example not provided with the light blocking layer.

As illustrated in FIG. 3B, in the display device according to the comparative example, e.g., light L1 emitted forward from a front surface of the light emitting element 112B is incident on the transparent substrate 121 through the corresponding opening 122H1 located in front of the light emitting element 112B, and is emitted to the outside. On the other hand, a portion of light L2 emitted from the front surface of the light emitting element 112B is reflected at a surface of the transparent substrate 121 and then reflected in the display device 100, and is emitted to the outside through another opening 122H2 other than the corresponding opening 122H1. Further, light L3 emitted from a side surface 112S of the light emitting element 112G is also emitted to the outside through another opening 122H3 other than the corresponding opening 122H2.

Therefore, in the general display device not provided with the light blocking layer, crosstalk of light occurs, and deterioration in image quality (such as change in color) of the display image may occur.

On the other hand, as illustrated in FIG. 3A, according to the display device 100 of the present invention, light L2 emitted from the light emitting element 112 and reflected at the surface of the transparent substrate 121 is absorbed by the light blocking layer 113, so that the light L2 may not be emitted to the outside through another opening 122H. Further, according to the display device 100 of the present invention, since the side surface 112S of the light emitting element 112 is covered with the light blocking layer 113, light emitted from the side surface 112S of the light emitting element 112 may also not be emitted to the outside through another opening 122H.

Therefore, according to the display device 100 of the present embodiment, crosstalk of light does not occur, and a high-quality image may be displayed.

### <Thickness of Transparent Substrate 121>

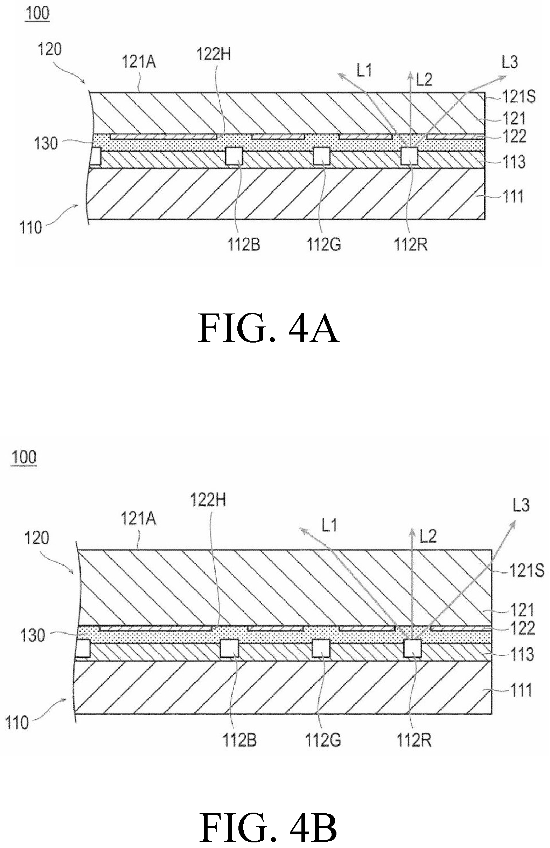

Next, the thickness of the transparent substrate 121 of the display device 100 is described in detail with reference to FIGS. 4A and 4B. As described above, in the display device 100 of the present embodiment, a thin glass substrate having a thickness of about 100 µm is used as the transparent substrate 121.

FIG. 4A is a view illustrating an optical path when the transparent substrate 121 is thin, and FIG. 4B is a view illustrating an optical path when the transparent substrate 121 is thick.

As illustrated in FIG. 4B, when the transparent substrate 121 is thick, a portion of light L3 among light L1, L2, L3 emitted from the light emitting element 112R installed at an end of the display substrate 110 may reach two opposite ends 121S in a direction in which the transparent substrate 121 extends after passing through the opening 122H. The light L3 reaching two opposite ends 121S in the direction in which the transparent substrate 121 extends may generate linear light (White Seam) at a corner portion of the display device 100, e.g., when connecting a plurality of display devices 100, which is unpreferable.

On the other hand, as illustrated in FIG. 4A, when the transparent substrate 121 is thin, light L1, L2, L3 emitted from the light emitting element 112R installed at the end of the display substrate 110 is emitted to the outside from a front surface 121A of the transparent substrate 121 after passing through the opening 122H without reaching two opposite ends 121S in the direction in which the transparent substrate 121 extends. Therefore, according to the display device 100 using the thin glass substrate, when connecting a plurality of display devices 100, linear light does not occur at the corner portion of the display device 100, and the image quality of the display image is enhanced.

As described above, in the display device 100 of the present embodiment, the thickness of the transparent substrate 121 is preset so that light emitted from the light emitting element 112 located at the end of the circuit board 111 does not reach two opposite ends 121S in the direction in which the transparent substrate 121 extends.

### <Method for manufacturing display device 100>

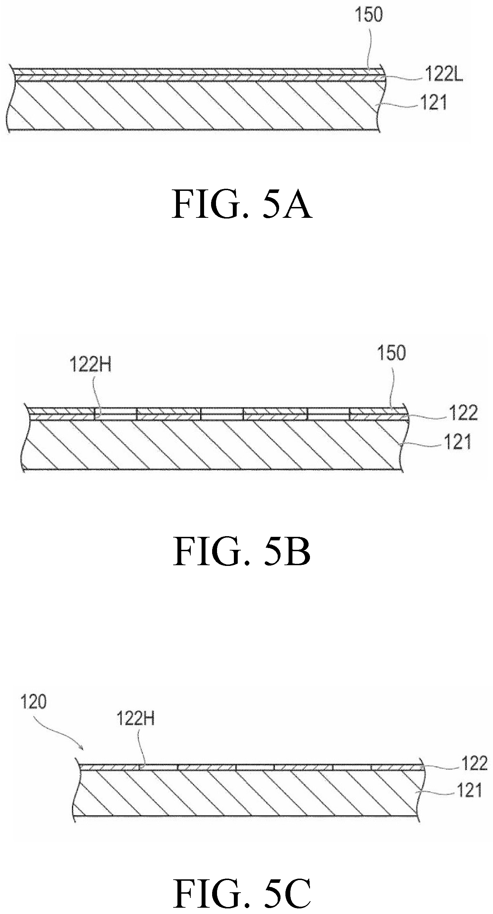

Next, a method for manufacturing the display device 100 is described with reference to FIGS. 5A to 5F.

First, a metal film 122L formed of an alloy of aluminum and niobium is formed on the transparent substrate 121, and a photoresist 150 is applied on the metal film 122L (see FIG. 5A). Subsequently, an opening 112H is formed in the metal film 122L using a photolithography process (see FIG. 5B). Thereafter, the reflective substrate 120 is completed by removing the photoresist 150 (see FIG. 5C).

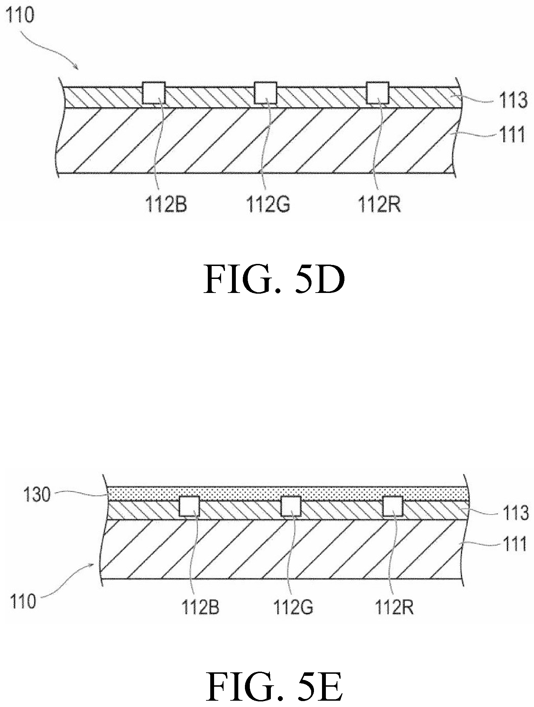

Subsequently, the light blocking layer 113, which is a black anisotropic conductive film, is formed on the circuit board 111, and the light emitting element 112 is embedded in the anisotropic conductive film, thereby completing the display substrate 110 provided with the light emitting element 112 and the light blocking layer 113 (see FIG. 5D).

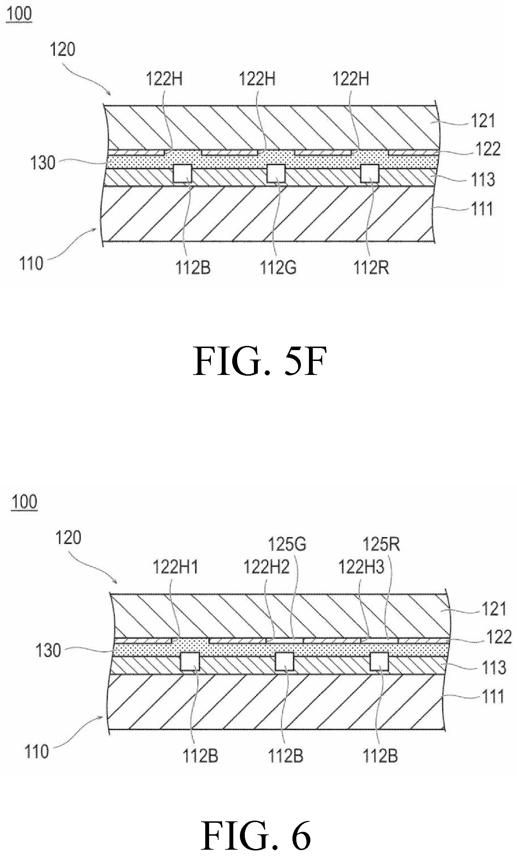

Subsequently, the transparent adhesive layer 130 is applied on the display substrate 110 (see FIG. 5E). Then, the reflective substrate 120 is bonded to the transparent adhesive layer 130 on the display substrate 110 such that the reflective layer 122 of the transparent substrate 121 faces the display substrate 110, thereby completing the display device 100 (see FIG. 5F).

Further, the material of each member of the display device 100 is not limited to the material, and various materials may be used. For example, the transparent substrate 121 may be a transparent resin substrate, and the reflective layer 122 may be composed of an arbitrary metal such as silver, aluminum, a silver alloy, and an aluminum alloy. Further, the light blocking layer 113 is not limited to the black anisotropic conductive film, and may be composed of a black matrix material or the like. When the light blocking layer is a black matrix material, the light emitting element 112 may be mounted on the circuit board 111 by a bonding technique such as soldering. Further, the color of the light blocking layer 113 is not limited to black, and an arbitrary color capable of absorbing light may be used.

### (Modified Example)

Next, a modified example of the display device 100 according to the present embodiment is described with reference to FIG. 6.

FIG. 6 is a cross-sectional view illustrating a schematic configuration of the display device 100 according to the modified example. The display device according to the modified example differs from the display device according to the first embodiment in that color display is realized using a color conversion layer. Further, the same reference numerals are given to the same configurations as those of the first embodiment, and the description thereof is omitted.

The display device 100 according to the modified example may include a display substrate 110 in which a plurality of light emitting elements 112B are disposed in an array shape, and a reflective substrate 120 in which a plurality of openings 122H corresponding to the plurality of light emitting elements 112B are formed. The display substrate 110 and the reflective substrate 120 may be bonded to each other through a transparent adhesive layer 130.

The display substrate 110 may have a plurality of blue light emitting elements 112B mounted on a circuit board 111. A light blocking layer 113 may be formed in an area other than the area where the blue light emitting element 112B is installed on the display substrate 110.

The reflective substrate 120 may have a reflective layer 122 in which openings 122H1, 122H2, 122H3 are formed at positions corresponding to the blue light emitting elements 112B. Color conversion layers 125G, 125R may be formed in two openings 122H2, 122H3 among three openings 122H1, 122H2, 122H3 corresponding to three blue light emitting elements 112B constituting one pixel. The color conversion layers 125G, 125R may include a green conversion layer 125G formed of a color conversion material converting blue light into green light, and a red conversion layer 125R formed of a color conversion material converting blue light into red light. The color conversion material includes a phosphor or a quantum dot.

According to the display device 100 configured as described above, a color image may be realized using only the blue light emitting element 112B. Further, since the light blocking layer 113 is formed on the circuit board 111, a portion of light emitted from a specific light emitting element 112B may not reach another opening 122H other than the corresponding opening 122H. More specifically, e.g., it may be configured such that light emitted from the blue light emitting element 112B corresponding to the opening 122H1 in which the color conversion layer is not formed is reflected at the surface of the transparent substrate 121 and does not enter the color conversion layers 125G, 125R formed in the other openings 122H2, 122H3.

Therefore, according to the display device 100 of the modified example, e.g., when displaying only a blue image, green light or red light is not mixed with blue light and emitted to the outside, so that a high-quality blue image may be displayed.

Further, the light emitting element according to the modified example is not limited to the blue light emitting element, and a light emitting element emitting light of a specific wavelength such as white light or ultraviolet light may be used. The color conversion material constituting the color conversion layer may be changed according to light emitted by the light emitting element.

### (Second Embodiment)

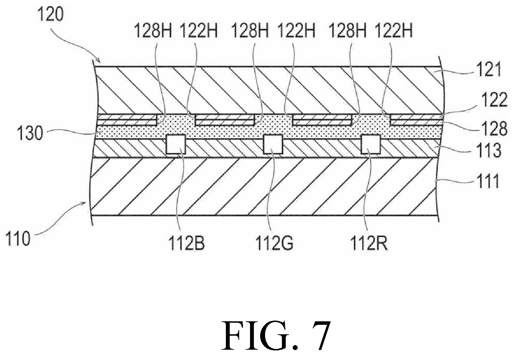

Next, a display device 100 according to a second embodiment of the present invention is described with reference to FIG. 7. The display device according to the second embodiment may differ from the display device according to the first embodiment in that a light blocking layer is additionally formed on a reflective substrate. Further, the same reference numerals are given to the same configurations as those of the first embodiment, and the description thereof is omitted.

The display device 100 according to the present embodiment may include a display substrate 110 in which a plurality of light emitting elements 112B, 112G, 112R are disposed in an array shape, and a reflective substrate 120 in which a plurality of openings 122H corresponding to the plurality of light emitting elements 112B, 112G, 112R are formed. The display substrate 110 and the reflective substrate 120 may be bonded to each other through a transparent adhesive layer 130.

The display substrate 110 may be configured to have a plurality of light emitting elements 112B, 112G, 112R mounted on a circuit board 111. The light emitting element 112 may be mounted on the circuit board 111 by a bonding technique such as soldering.

According to an embodiment, the reflective substrate 120 may further include a second light blocking layer 128.

The reflective substrate 120 has a reflective layer 122 in which an opening 122H is formed at a position corresponding to the light emitting element 112, and a second light blocking layer 128 may be further formed on the reflective layer 122. Similar to the reflective layer 122, an opening 128H is formed in the second light blocking layer 128 at a position corresponding to the light emitting element 112, and light emitted from the light emitting element 112 may be emitted to the outside through the openings 122H, 128H. The light blocking layer 128 is composed of, e.g., a black matrix material, and may absorb a portion of light emitted from the light emitting element 112.

According to the display device 100 configured as described above, a portion of light emitted from the light emitting element 112 is absorbed by the second light blocking layer 128 formed on the transparent substrate 121, and the portion of light may not be emitted to the outside from another opening 122H. Therefore, according to the display device 100 of the present embodiment, crosstalk of light does not occur, and a high-quality image may be displayed.

### <Third embodiment>

In the first and second embodiments described above, the case where the display substrate 110 and the reflective substrate 120 have the same size has been described as an example. However, the sizes of the display substrate 110 and the reflective substrate 120 may be different.

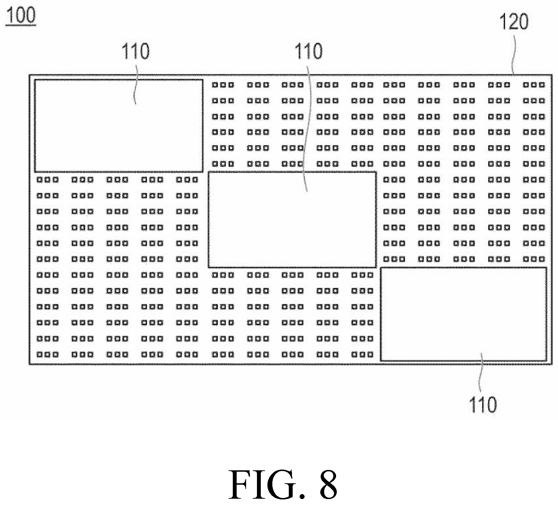

As illustrated in FIG. 8, in the display device 100 according to a third embodiment of the present invention, when viewed from above, the size of the reflective substrate 120 may be formed to be larger than the size of the display substrate 110. Further, when viewed from above, the display substrate 110 may be configured to overlap the reflective substrate 120. Further, a plurality of small display substrates 110 are bonded to the large reflective substrate 120.

According to an embodiment, it is possible to increase the size of the display device 100 without increasing the size of the display substrate 110.

### <Display System>

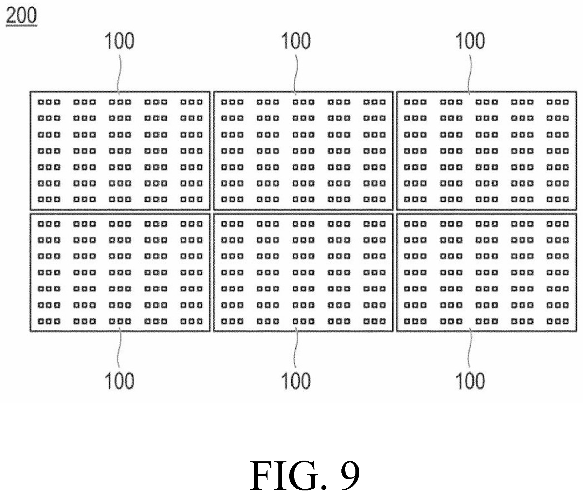

Finally, a display system 200 according to an embodiment of the present invention is described with reference to FIG. 9. The display system 200 according to the present embodiment includes a plurality of display devices 100.

As illustrated in FIG. 9, the display system 200 is configured by disposing the plurality of display devices 100 in a tile shape. The display substrate 110 and the reflective substrate 120 of the display device 100 have about the same size.

According to an embodiment, the degree of freedom in the shape of the display plane is enhanced, and for example, a large mirror display having an L-shaped display plane may be easily provided.

The present invention is not limited to the above-described embodiments, and various modifications may be made within the scope of the claims.

For example, in the above-described embodiment, the case where the size of the opening formed in the reflective layer is larger than the size of the front surface of the light emitting element has been described as an example. However, the size of the opening is not limited to being larger than the size of the front surface of the light emitting element. The size of the opening may be equal to the size of the front surface of the light emitting element, or may be smaller than the size of the front surface of the light emitting element. Further, the shape of the opening is not particularly limited, and is appropriately changed according to the shape of the front surface of the light emitting element.

Further, in the embodiment, the case where the light emitting element is an inorganic light emitting element (micro LED) has been described as an example. However, the light emitting element is not limited to the inorganic light emitting element, and various light emitting elements such as an organic light emitting element may be applied.

Further, in the above-described embodiment, the reflective layer was formed on a surface (rear surface) of the transparent substrate on a side facing the display substrate. However, the reflective layer may be formed on a surface (front surface) of the transparent substrate on an opposite side from the display substrate. In this case, it is preferable to form an anti-oxidation film on the reflective layer.

## Claims

1. A display device, comprising:
a plurality of light emitting elements disposed to be spaced apart on a circuit board and configured to emit light forward, respectively;
a reflective layer formed on a transparent substrate facing the circuit board, the reflective layer comprising openings formed at positions corresponding to the light emitting elements, configured such that light emitted from the light emitting elements passes through the openings and is emitted forward, and configured to reflect light from the front; and
a light blocking layer formed between the circuit board and the transparent substrate and configured to absorb a portion of light emitted from the light emitting elements such that light emitted from the light emitting elements does not reach openings disposed at positions not corresponding to the light emitting elements.

2. The display device of claim 1, wherein the light blocking layer is formed in an area other than an area where the light emitting elements are installed on the circuit board.

3. The display device of claim 2, wherein the light blocking layer is configured to cover side surfaces of the light emitting elements and to absorb light emitted from the side surfaces of the light emitting elements.

4. The display device of claim 1 or 2, wherein the reflective layer further comprises a second light blocking layer formed on a surface facing the light blocking layer.

5. The display device of claim 1 or 2, further comprising a transparent adhesive layer formed between the circuit board and the transparent substrate and bonding the circuit board and the transparent substrate.

6. The display device of claim 1 or 2, wherein the plurality of light emitting elements comprise a blue light emitting element configured to emit blue light, a green light emitting element configured to emit green light, and a red light emitting element configured to emit red light.

7. The display device of claim 1 or 2, wherein the plurality of light emitting elements are light emitting elements that emit light of a specific wavelength, and
wherein the display device further comprises a color conversion layer that converts light of the specific wavelength into light of another wavelength and emits the converted light.

8. The display device of claim 7, wherein the color conversion layer is formed in the openings.

9. The display device of claim 1 or 2, wherein the transparent substrate has a thickness equal to or less than a preset thickness so that light emitted from the light emitting elements does not reach both ends of the transparent substrate in a direction in which the transparent substrate extends.

10. The display device of claim 1 or 2, wherein the light emitting elements are configured to overlap the openings when viewed from above.

11. The display device of claim 1 or 2, wherein the light emitting elements are micro light emitting diodes (LEDs).

12. The display device of claim 1 or 2, wherein the transparent substrate is larger than the circuit board when viewed from above, and wherein a plurality of the circuit boards are bonded to the transparent substrate.

13. A display system comprising a plurality of the display devices of claim 1 or 2, wherein the plurality of display devices, each having the transparent substrate and the circuit board of an identical size, are disposed in a tile shape.
